# EUROPÄISCHE PATENTSCHRIFT

(11) **EP 4 217 222 B1**
(45) Veröffentlichungstag und Bekanntmachung des Hinweises auf die Patenterteilung: **30.10.2024**
(21) Anmeldenummer: 21782948.0
(22) Anmeldetag: 23.09.2021
(51) Int. Cl.: B60K 35/00, B60K 35/22, B60K 35/50, B60K 35/53

(54) **AUS- UND EINFAHRBARE ANZEIGEVORRICHTUNG FÜR EIN FAHRZEUG**
EXTENDABLE AND RETRACTABLE DISPLAY DEVICE FOR A VEHICLE
DISPOSITIF D'AFFICHAGE DÉPLOYABLE ET ESCAMOTABLE POUR VÉHICULE

(30) Priorität: 23.09.2020 DE 102020124829; 24.09.2020 DE 102020124958
(43) Veröffentlichungstag der Anmeldung: 02.08.2023
(73) Patentinhaber: BHTC GmbH, 59557 Lippstadt (DE)
(72) Erfinder: BESCHNITT, Alexander, 59557 Lippstadt (DE); LANDGRÄBER, Björn, 59557 Lippstadt (DE)
(74) Vertreter: dompatent von Kreisler Selting Werner - Partnerschaft von Patent- und Rechtsanwälten mbB
(86) Internationale Anmeldenummer: PCT/EP2021/076135
(87) Internationale Veröffentlichungsnummer: WO 2022/063866

(56) Entgegenhaltungen:
- EP-A2- 1 245 429
- US-A1- 2011 018 820
- US-B1- 8 953 327

## Beschreibung

Die Erfindung betrifft eine aus- und einfahrbare Anzeigevorrichtung für ein Fahrzeug.

Für den Consumer-Bereich werden seit kurzer Zeit Fernsehgeräte mit aufrollbaren Anzeigevorrichtungen angeboten. Dabei kommen flexible Displayfolien mit OLED-Technologie zum Einsatz, die zum Teil mit segmentierten Displayfolienträgern, die einzelne Lamellen aufweisen, versteift sind.

Im Automotive-Bereich ist es mitunter gewünscht, die heutzutage üblichen Displays bei Nichtgebrauch verstauen zu können. Insoweit bieten sich flexible Displayfolien auch für den Automotive-Bereich an. Aus der eine vorangemeldete und nachveröffentlichte deutsche Patentanmeldung betreffenden DE-A-10 2019 127 570 und aus EP-A-1 637 387, EP-A-1 245 429, US-A-2017/0217290 und US-A-2011/0018820 sind jeweils aus- und einfahrbare Displays für Fahrzeuge bekannt.

Ferner ist eine aus- und einfahrbare Anzeigevorrichtung für ein Fahrzeug mit den Merkmalen des Oberbegriffs des Anspruchs 1 aus US-B-8 953 327 bekannt.

Ein gewisses Problem bei der Verwendung von flexiblen Displayfolien in Fahrzeugen besteht darin, dass in einem Fahrzeug auf die Anzeigevorrichtung Erschütterungen einwirken, die der Beibehaltung einer Stabilisierung der flexiblen Displayfolie im ausgefahrenen Zustand nicht zuträglich sind.

Aufgabe der Erfindung ist es daher, eine aus- und einfahrbare Anzeigevorrichtung für ein Fahrzeug mit flexiblem Display zu schaffen, dessen Stabilität im ausgefahrenen Zustand auch bei Vibrationen, wie sie bei einer Fahrt auftreten, gegeben ist.

Zur Lösung dieser Aufgabe wird mit der Erfindung eine aus- und einfahrbare Anzeigevorrichtung für ein Fahrzeug vorgeschlagen, wobei die Anzeigevorrichtung versehen ist mit
- einer flexiblen Displayfolie in OLED-Technologie, die eine eine Anzeigefläche aufweisende Vorderseite sowie eine Rückseite und einen oberen Endabschnitt aufweist, an den sich ein sich bis zu einem unteren Ende der Displayfolie erstreckender Hauptabschnitt der Displayfolie anschließt,
- einem flexiblen Displayfolienträger, der an der Rückseite der Displayfolie an dieser befestigt oder mit dieser vermittels einer Zwischenschicht aus insbesondere elastischem Material verbunden ist sowie versehen ist mit einem oberen Endabschnitt, an den sich ein sich bis zu einem unteren Ende des Displayfolienträgers erstreckender Hauptabschnitt des Displayfolienträgers anschließt, wobei der obere Endabschnitt des Displayfolienträgers an dem oberen Endabschnitt der Displayfolie anliegt und versteift ist,
- einem Gehäuse, in das die Displayfolie mitsamt dem Displayfolienträger einfahrbar und aus dem die Displayfolie mitsamt dem Displayfolienträger ausfahrbar ist,
- mindestens einem motorisch antreibbaren, längenveränderbaren Stellglied, das ein sich im und/oder am Gehäuse abstützendes erstes Ende und ein zweites Ende aufweist, an dem der obere Endabschnitt des Displayfolienträgers befestigt ist, und
- einer Führungseinrichtung in dem Gehäuse zur Führung von Displayfolie und Displayfolienträger in zumindest einem Teilbereich von deren Hauptabschnitten entlang eines Krümmungsradius über weniger als 180 Grad oder weniger als 135 Grad oder weniger als 90 Grad bei einem durch Längenveränderung des mindestens einen Stellglieds erfolgenden Aus- und Einfahren von zumindest Teilbereichen der Hauptabschnitte von Displayfolie und Displayfolienträger aus dem Gehäuse und in das Gehäuse.

Die Erfindung ist sinngemäß darin zu sehen, dass für das Aus- und Einfahren der Displayfolie mindestens ein längenveränderbares Stellglied eingesetzt wird, das motorisch betrieben wird. Die flexible Displayfolie ist durch einen ebenfalls flexiblen Displayfolienträger versteift, der beispielsweise eine Metallfolie aufweisen kann. Die in der OLED-Technologie ausgeführte flexible Displayfolie weist eine Anzeigefläche an ihrer Vorderseite und eine Rückseite auf. Die Displayfolie weist ferner an ihrem oberen Rand einen sich an diesen anschließenden oberen Endabschnitt auf, an den sich wiederum ein bis zum unteren Rand der Displayfolie erstreckender Hauptabschnitt anschließt. In gleicher Weise ist der Displayfolienträger in einen oberen Endabschnitt und in einen Hauptabschnitt (gedanklich) unterteilt. Im oberen Endabschnitt ist der Displayfolienträger versteift. In diesem Bereich greift das mindestens eine motorisch antreibbare, längenveränderbare Stellglied an, das in dem oberen Endabschnitt des Displayfolienträgers an dessen Rückseite befestigt ist.

Die erfindungsgemäße Anzeigevorrichtung weist darüber hinaus ein Gehäuse auf, in das die Displayfolie mitsamt dem Displayfolienträger einfahrbar und aus dem Displayfolie und Displayfolienträger ausfahrbar sind. Im vollständig eingefahrenen Zustand von Displayfolie und Displayfolienträger können beide mit zumindest einem Teil ihrer oberen Endabschnitte noch aus dem Gehäuse heraus vorstehen.

Innerhalb des Gehäuses befindet sich eine Führungseinrichtung zum Führen von Displayfolie und Displayfolienträger in zumindest einem Teilbereich ihrer Hauptabschnitte, und zwar entlang eines Krümmungsradius oder allgemeiner ausgedrückt einer Krümmungslinie, der/die sich über weniger als 180 Grad oder weniger als 135 Grad oder weniger als 90 Grad erstreckt. Durch diese Führungseinrichtung kommt es lediglich zu einer Umlenkung der Hauptabschnitte von Displayfolie und Displayfolienträger in dem Gehäuse und nicht zu einem Aufwickelvorgang, was den Vorteil mit sich bringt, dass die der Displayfolie und den Displayfolienträger zu verleihende Krümmung im eingefahrenen Zustand der Anzeigevorrichtung größer ausgelegt werden kann. Insbesondere bei einer beispielsweise etwa 90 Grad Umlenkung verlaufen also die Displayfolie und der Displayfolienträger nach der Umlenkung geradlinig weiter, was eine gewisse Tiefe des Gehäuses voraussetzt, die aber im Regelfall tolerierbar ist, was die bauraumtechnischen Gegebenheiten insbesondere im Bereich der Instrumententafel eines Fahrzeugs betrifft.

Durch die Bereitstellung eines flexiblen Displayfolienträgers in Folienform aus beispielsweise Metall lässt sich die flexible Displayfolie ganzflächig stabilisieren. Wenn mehrere längenveränderbare Stellglieder nebeneinander angeordnet und über die Breite von Displayfolie und Displayfolienträger verteilt angeordnet werden, so ergibt sich eine zusätzliche Abstützung und damit Stabilisierung der flexiblen Displayfolie, so dass beim Fahren auftretende Erschütterungen sich nicht in Form von Vibrationen der Displayfolie auswirken können.

In zweckmäßiger Weiterbildung der Erfindung ist vorgesehen, dass das mindestens eine Stellglied mindestens zwei zwischen den beiden Enden angeordnete Stellgliedelemente aufweist, wobei jeweils benachbarte Stellgliedelemente aneinander und/oder ineinander verschiebbar geführt sind. Hier lassen sich teleskopierbare Stellglieder mit beispielsweise Spindelantrieben einsetzen. Aber auch andere längenveränderbare Stellgliedkonstruktionen mit Ausfahrantrieben sind einsetzbar.

Zur Erzielung eines möglichst flachbauenden längenveränderbaren Stellglieds ist es von Vorteil, wenn das Stellglied ein im Wesentlichen C-förmiges, mit einer geschlossenen Seite und einer offenen Seite versehenes, erstes Stellglied-Profilelement, ein verschiebbar im ersten Stellglied-Profilelement geführtes, ebenfalls im Wesentlichen C-förmiges, mit einer geschlossenen Seite und einer offenen Seite versehenes, zweites Stellgliedprofilelement, dessen geschlossene Seite der geschlossenen Seite des ersten Stellgliedprofilelements zugewandt ist, und ein verschiebbar im zweiten Stellgliedprofilelement geführtes, im Wesentlichen C-förmiges, mit einer geschlossenen Seite und einer offenen Seite versehenes, drittes Stellgliedprofilelement aufweist, dessen geschlossene Seite die offene Seite des zweiten Stellgliedprofilelements überdeckt. Das C-förmige Profil der einzelnen Stellgliedelemente weist eine im Wesentlichen geradlinige streifenförmige Rückwand auf, deren einander abgewandte obere und untere Ränder umgebogen sind, so dass im Querschnitt ein "flaches C" entsteht. Die, wie oben beschrieben, Ineinanderschachtelung dreier derartiger Elemente erlaubt dann den typischerweise erforderlichen Ausfahrhub der Anzeigevorrichtung, wie er im Automotive-Bereich anzutreffen ist, was wiederum mit den im Automotive-Bereich vorteilhafterweise verwendbaren Größen von Display im Zusammenhang steht.

Anstelle der Verwendung mehrerer motorisch antreibbarer Stellglieder kann eine zusätzliche Versteifung und Stabilität der Anzeigevorrichtung im ausgefahrenen Zustand auch durch mindestens eine längenveränderbare Stütze mit einem sich im Gehäuse abstützenden ersten Ende und einem zweiten Ende erzielt werden, an dem der obere Endbereich des Displayfolienträgers befestigt ist. Derartige Stützen weisen keine Antriebe auf, sind also beispielsweise teleskopierbar oder mit auf andere Art und Weise aneinander verschiebbar geführten Stützelementen versehen.

Auch hinsichtlich der Ausgestaltung der längenveränderbaren Stütze kann es von Vorteil sein, wenn die Stütze ein im Wesentlichen C-förmiges, mit einer geschlossenen Seite und einer offenen Seite versehenes, erstes Stützprofilelement, ein verschiebbar im ersten Stützprofilelement geführtes, ebenfalls im Wesentlichen C-förmiges, mit einer geschlossenen Seite und einer offenen Seite versehenes, zweites Stützprofilelement, dessen geschlossene Seite der geschlossenen Seite des ersten Stützprofilelements zugewandt ist, und ein verschiebbar im zweiten Stützprofilelement geführtes, im Wesentlichen C-förmiges, mit einer geschlossenen Seite und einer offenen Seite versehenes, drittes Stützprofilelement aufweist, dessen geschlossene Seite die offene Seite des zweiten Stützprofilelements überdeckt.

Mit Hilfe des mindestens einen motorisch betreibbaren Stellgliedes und mit Hilfe der gegebenenfalls vorhandenen Stütze lässt sich nun die Displayfolie im aufgespannten Zustand halten. Dabei liegen das oder die Stellglieder bzw. das oder die Stützen zweckmäßigerweise an der Rückseite des Displayträgers an und stützen die Displayfolie insoweit hinsichtlich auf der Anzeigefläche wirkenden Kräfte. Damit nun auch die Displayfolie gegen "Abziehkräfte" gesichert ist, ist gemäß einer vorteilhaften Weiterbildung der Erfindung vorgesehen, dass das mindestens eine Stellglied oder zumindest eines seiner Stützelemente und/oder, sofern vorhanden, die mindestens eine Stütze oder zumindest eines ihrer Stützelemente eine dem Displayfolienträger zugewandte Innenseite aufweist, an der eine Aufnahmenut ausgebildet oder angeordnet ist, dass abstehend von der der Displayfolie abgewandten Rückseite des Displayfolienträgers in dessen Hauptabschnitt mindestens ein Halteelement angeordnet ist, und zwar auf einer gedachten Linie, die beim Aus- und Einfahren von Displayfolie und Displayfolienträger der Aufnahmenut gegenüberliegt, und dass das mindestens eine Halteelement beim Ausfahren von Displayfolie und Displayfolienträger in die Aufnahmenut eintaucht und sich beim Einfahren von Displayfolie und Displayfolienträger aus der Aufnahmenut herausbewegt. Hierbei ist es zweckmäßig, wenn das mindestens eine Halteelement ein dem Displayfolienträger abgewandtes verbreitertes oder abgewinkelt ausgebildetes Ende zum Hintergreifen eines Aufnahmeschlitzes der Aufnahmenut aufweist. Die Aufnahmenut an dem mindestens einen Stellglied bzw. an der mindestens einen Stütze ist zu ihrem nach unten zum Gehäuse weisenden Ende zweckmäßigerweise offen, so dass nun in diese Öffnung ein Halteelement eintauchen kann, das aufgrund seiner Verbreiterung am in die Aufnahmenut eingetauchten Ende gegen ein Herausbewegen aus dem Aufnahmeschlitz der Aufnahmenut gehindert ist. Auf diese Weise wird nun die Displayfolie auch dann an dem Stellglied bzw. an der Stütze gehalten, wenn Momente auf die Displayfolie wirken, die andernfalls zu einem Ablösen des Displayfolienträgers vom Stellglied bzw. von der Stütze führen würden.

Wie bereits oben beschrieben, können Displayfolie und Displayfolienträger im eingefahrenen Zustand noch geringfügig aus dem Gehäuse herausragen. Sofern dies unerwünscht ist, die gesamte Displayfolie mit Displayfolienträger also im Gehäuse verstaubar sein soll, ist es von Vorteil, wenn das mindestens eine Stellglied und, sofern vorhanden, die mindestens eine Stütze zum Einschwenken der oberen Endabschnitte von Displayfolie und Displayfolienträger im eingefahrenen Zustand in das Gehäuse an dem jeweiligen ersten Ende im Gehäuse schwenkbar gelagert ist oder sind.

Durch die schwenkbare Lagerung von Stellglied bzw. Stütze kann es zweckmäßig sein, dass das zweite Ende des Stellglieds und, sofern vorhanden, das zweite Ende der mindestens einen Stütze gelenkig an dem oberen Endabschnitt des Displayfolienträgers angeordnet ist.

Durch das Verschwenken von Stellglied und/oder Stütze krümmt sich nun der obere Endabschnitt von Displayfolie und Displayfolienträger in das Gehäuse hinein. Stütze und Stellglied sollten aber möglichst nahe an dem Displayfolienträger angeordnet sein, wenn dieser zusammen mit der Displayfolie ausgefahren ist. Eine derartige Anordnung ist aber der Krümmung von Displayfolie und Displayfolienträger in deren oberen Endabschnitten nicht zuträglich. Daher ist bei einer weiteren zweckmäßigen Ausgestaltung der Erfindung vorgesehen, dass das erste Ende des mindestens einen Stellglieds und, sofern vorhanden, das erste Ende der mindestens einen Stütze im eingefahrenen Zustand von Displayfolie und Displayfolienträger von der Rückseite des Displayfolienträgers abrückbar und in der abgerückten Position in das Gehäuse einschwenkbar ist bzw. sind, wobei insbesondere im eingeschwenkten Zustand der Krümmungsgrad des an den oberen Endabschnitt angrenzenden Teilbereichs des Hauptabschnitts von Displayfolie und Displayfolienträger durch im Gehäuse angeordnete Anlageelemente definiert ist.

Wie bereits oben kurz erwähnt, können auch mehrere Stellglieder verwendet werden. So ist es beispielsweise denkbar, zwei Stellglieder einzusetzen, die beidseitig von Displayfolie und Displayfolienträger angeordnet und mit dem oberen Endabschnitt des Displayfolienträgers verbunden sind. Bei einer derartigen Anordnung der Stellglieder oder auch eines Stellglieds und einer Stütze können die beiden Stellglieder bzw. die eine Stütze und das eine Stellglied im eingefahrenen Zustand verschwenkt werden, um den ggf. im eingefahrenen Zustand noch vorhandenen Überstand von Displayfolie und Displayfolienträger aus dem Gehäuse in das Gehäuse hinein zu verbringen. Die unteren Enden von Stellglied und Stütze müssten dann, wie oben beschrieben, verschwenkbar sein, benötigen aber nicht noch zusätzlich eine translatorische Bewegungsmöglichkeit.

Im eingeschwenkten Zustand der oberen Endabschnitte von Displayfolie und Displayfolienträger in das Gehäuse hinein werden die besagten Endabschnitte längs einer Krümmung verstaut. Um den Krümmungsgrad zu definieren und zu bestimmen, bietet es sich an, im Gehäuse Anlageelemente vorzusehen, die lateral der Displayfolie bzw. des Displayfolienträgers angeordnet sind und diesen lateral stützen. Durch die Anlageelemente wird dem typischerweise versteiften Endabschnitt von Displayfolie und Displayfolienträger eine vorgegebene minimal zulässige Krümmung verliehen. Denn sowohl hinsichtlich der Führung von Displayfolie und Displayfolienträger beim Verstauen der Anzeigevorrichtung ist es hinsichtlich der Vermeidung von Materialermüdungen und damit verbundenen Beschädigungen der Funktion der Displayfolie von Vorteil, wenn die Krümmungsradien ein vorgegebenes Mindestmaß nicht unterschreiten.

In weiterer vorteilhafter Ausgestaltung der Erfindung ist vorgesehen, dass die Führungseinrichtung zwei einander gegenüberlegende Führungsschlitze aufweist und dass der Displayfolienträger längs seines Hauptabschnitts verlaufende Lateralränder aufweist, von denen zum Führen des Displayfolienträgers mit dem Führungsschlitz zusammenwirkende Führungsstifte lateral ab- oder überstehen. Die Führungsschlitze wirken wie Kulissen, an denen Führungsstifte geführt sind, die ihrerseits lateralrandseitig von dem Displayfolienträger abstehen.

Genauso wie der obere Endabschnitt des Displayfolienträgers versteift ist, kann auch sein Hauptabschnitt in dem dem oberen Endabschnitt abgewandten unteren Endbereich eine Versteifungszone aufweisen. Diese Versteifungszone kann dazu genutzt werden, um an ihr ein Trägerelement zu verankern oder auf andere Art und Weise zu befestigen, das wiederum eine starre oder flexible Leiterplatine trägt. Denn die Ansteuerung der OLED-Elemente der Displayfolie muss, um flexible Kabelverbindungen vermeiden zu können, mit Displayfolie und Displayfolienträger mitbewegt werden, wenn die Anzeigevorrichtung aus- und eingefahren wird.

Die Führungseinrichtung kann darüber hinaus zweckmäßigerweise zwei einander gegenüberliegende Führungskörper aufweisen, die drehbar gelagert sind und jeweils einen gekrümmten Außenrand aufweisen, und dass die Führungskörper beim Ein- und Ausfahren von Displayfolie und Displayfolienträger verschwenken und dabei den Displayfolienträger lateralrandseitig stützen. Diese Führungskörper stützen den Displayfolienträger lateralrandseitig ab und können zusätzlich zu den Führungsstiften und den Führungsschlitzen der Führungseinrichtung eingesetzt werden. Die Führungskörper sind zum beim Einfahren von Displayfolie und Displayfolienträger erfolgenden Mitnehmen des Displayfolienträgers mit diesem mechanisch gekoppelt.

Zweckmäßig kann es sein, wenn die Führungskörper als Teilscheibenkörper ausgebildet sind, die sich über einen Winkel von weniger als 180 Grad oder weniger als 135 Grad oder weniger als 90 Grad erstrecken. Die Führungskörper können also sozusagen als Halb- oder Viertelkreisscheiben ausgebildet sein.

Alternativ zu Teilscheibenkörpern können die Führungskörper als Teilringkörper ausgebildet sein, die sich über einen Winkel von weniger als 180 Grad oder weniger als 135 Grad oder weniger als 90 Grad erstrecken.

Damit die Führungskörper mit dem Displayfolienträger beim Einfahren und ggf. auch beim Ausfahren mechanisch zusammenwirken können, sind sie zweckmäßigerweise mit Mitnehmerenden versehen, an denen sie mit dem Displayfolienträger zusammenwirken. An den Mitnehmerenden jedes Führungskörpers kann ein lateralrandseitig des Displayfolienträgers überstehender Mitnehmerstift angeordnet sein, der in eine Stiftaufnahme an dem Displayfolienträger eintaucht. Hierbei ist es ferner von Vorteil, wenn die Mitnehmerstifte der Führungskörper als Führungsstifte in die Führungsschlitze der Führungseinrichtung eingetaucht sind. Der Mitnehmerstift hat also insoweit Führungsfunktion, wobei der Displayfolienträger weitere Führungsstifte aufweisen kann, die längs seiner Lateralränder des Hauptabschnitts angeordnet sein können.

Wie bereits oben beschrieben, kann der Displayfolienträger auch dazu beitragen, die Displayfolie einzufahren, wenn das mindestens eine Stellglied eingefahren wird. Die Steifigkeit des Displayfolienträgers, die trotz seiner für die Umlenkung im Gehäuse erforderlichen Flexibilität noch vorhanden ist, kann hier vorteilhafterweise ausgenutzt werden. Wesentlich sicherer allerdings ist es, wenn die Führungseinrichtung mit einer Vorspanneinheit zum automatischen Einfahren von Displayfolie und Displayfolienträger versehen ist. Dabei ist dann mit Vorteil vorgesehen, dass die Vorspanneinheit beim Ausfahren des mindestens einen Stellgliedes spannbar ist und beim zum Einfahren von Displayfolie und Displayfolienträger erfolgenden Einfahren des mindestens einen Stellglieds entspannbar ist.

Die Vorspanneinheit kann zweckmäßigerweise mindestens einen Antriebshebel mit Drehlager und einem Federspannmechanismus z. B. mit einer Schenkel-, Spiral- oder Schraubenfeder an seinem Drehlager aufweisen, wobei der mindestens eine Antriebshebel mit einem der Führungskörper mechanisch gekoppelt ist. Zweckmäßig ist es ferner, wenn die Vorspanneinheit zwei Antriebshebel aufweist, die jeweils mit einem anderen der Führungskörper mechanisch gekoppelt sind.

Zur weiteren Versteifung der Displayfolie im ausgefahrenen Zustand kann ferner vorgesehen sein, dass an der der Displayfolie abgewandten Rückseite des Displayfolienträgers ein Versteifungslamellen aufweisender Versteifungsträger angeordnet ist, dessen quer zur Ein- und Ausfahrrichtung von Displayfolie und Displayfolienträger verlaufende Verstärkungslamellen entlang von streifenförmigen Bereichen an dem Displayfolienträger befestigt sind und dass das mindestens eine Halteelement, sofern vorhanden, an einer der Versteifungslamellen oder dass mehrere Halteelemente, sofern vorhanden, an verschiedenen der Versteifungslamellen angeordnet sind. Die einzelnen Versteifungslamellen können über ihre gesamte Höhe und/oder Breite mit der Rückseite des Displayfolienträgers verbunden sein, was zweckmäßigerweise über flexible Zwischenschichten und klebend erfolgt. Die Versteifungslamellen können kunststoffumspritzte Kerne aus biegesteifem Material wie beispielsweise Metall aufweisen. Sie können flexibel durch beispielsweise Filmscharniere oder anders konstruierte Gelenke verbunden sein. Sofern Halteelemente zum Halten von Displayfolie und Displayfolienträger an Stellglied und Stütze im ausgefahrenen Zustand vorhanden sind, können diese Halteelemente an den Lamellen angeordnet sein. Selbiges gilt für Führungsstifte der Führungseinrichtung. Auch die zuvor beschriebenen Führungskörper können nun die Versteifungslamellen lateralrandseitig stützen, anstatt, wie zuvor beschrieben, am Displayfolienträger anzuliegen.

Die Erfindung wird nachfolgend anhand verschiedener Ausführungsbeispiele sowie unter Bezugnahme auf die Zeichnung näher erläutert. Im Einzelnen zeigen dabei:
- Fign. 1 bis 6: ein erstes Ausführungsbeispiel eines aus- und einfahrbaren Display für ein Fahrzeug,
- Fig. 7: ein zweites Ausführungsbeispiel eines aus- und einfahrbaren Display für ein Fahrzeug,
- Fign. 8 bis 11: schematisch einen Ein- und Ausfahrmechanismus für ein drittes Ausführungsbeispiel eines aus- und einfahrbaren Display für ein Fahrzeug,
- Fign. 12 und 13: eine Querschnittsansicht und eine perspektivische Ansicht eines längenveränderbaren Stellgliedes bzw. einer längenveränderbaren Stütze, und
- Fign. 14 bis 25: Einzelheiten weiterer Ausführungsbeispiele von aus- und einfahrbaren Display mit verschiedenen Konstruktionen für die Führung des flexiblen Display beim Ein- und Ausfahren desselben.

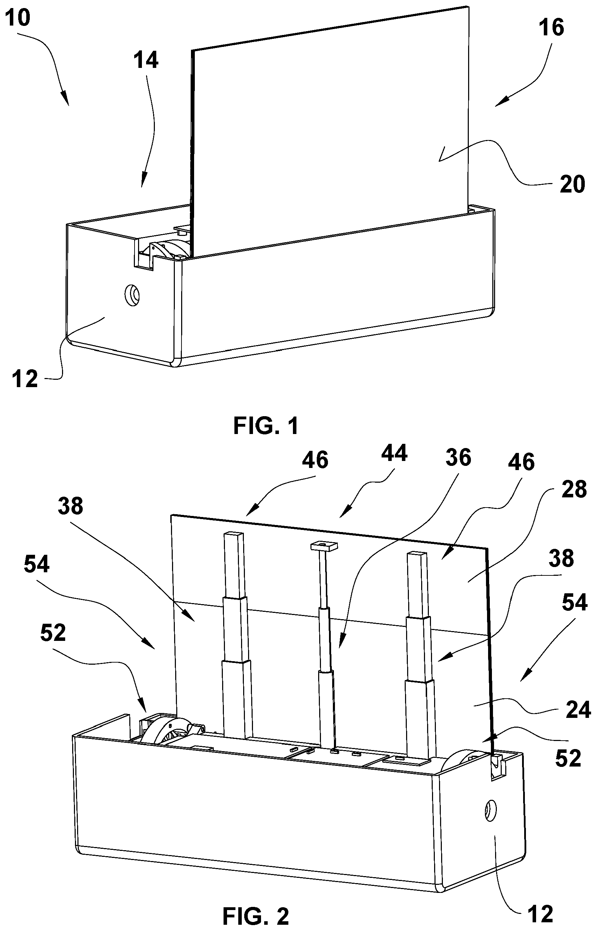

In den Fign. 1 bis 6 ist ein erstes Ausführungsbeispiel einer aus- und einfahrbaren Anzeigevorrichtung 10 für ein Fahrzeug gezeigt. Die Anzeigevorrichtung 10 weist ein Gehäuse 12 auf, das eine (in den Figuren nicht gezeigte) geschlossene Oberseite 14 aufweist, die mit einer Schlitzöffnung versehen ist, aus der ein Display 16 im Wesentlichen geradlinig ausfahrbar und in die dieses Display 16 einfahrbar ist. Das Display 16 weist eine OLED-Displayfolie 18 auf, die einen Anzeigefläche 20 definiert, welche von einem Schutzfilm abgedeckt ist. Die Displayfolie 18 und der Abdeckfilm 22 sind flexibel und entlang einer Krümmungslinie in dem Gehäuse 12 umlenkbar. An der Rückseite der Displayfolie 18 befindet sich ein dünner Displayfolienträger 24, der insbesondere ganzflächig mit der Rückseite der Displayfolie 18 durch beispielsweise eine Verklebung verbunden ist und in seinem oberen Endabschnitt 26 zusätzlich durch beispielsweise eine Platte 28 versteift ist. An den oberen Endabschnitt 26 schließt sich der Hauptabschnitt 30 des Displayfolienträgers 24 an. Auch die Displayfolie 18 weist einen oberen Endabschnitt 32 und einen sich dran anschließenden Hauptabschnitt 34 auf.

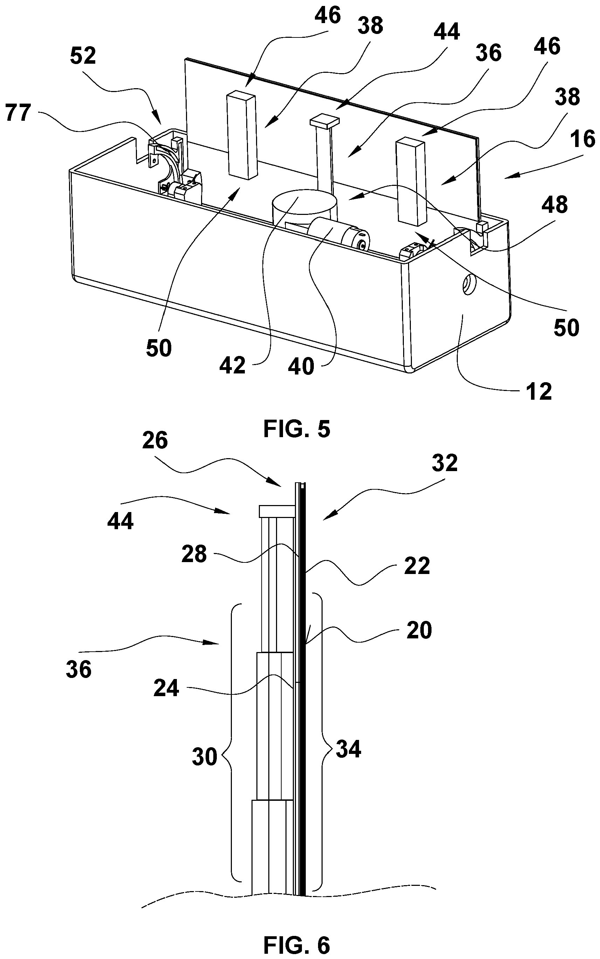

An der Rückseite des Displayfolienträgers 24 sind in diesem Ausführungsbeispiel in der Mitte ein längenveränderbares Stellglied 36 und beidseitig desselben zwei ebenfalls längenveränderbare Stützen 38 angeordnet. Das längenveränderbare Stellglied 36 ist motorisch angetrieben; in Fig. 5 sind ein Motor 40 und ein Getriebe 42 angedeutet. Die Stützen 38 sind längenveränderbar und fahren beim Ausfahren des Stellgliedes 36 auseinander und ziehen sich beim Einfahren des Stellgliedes 36 zusammen. Das Stellglied 36 und die Stützen 38 sind in diesem Ausführungsbeispiel teleskopierbar; aber auch andere Möglichkeiten der Längenveränderbarkeit dieser Elemente sind im Rahmen der Erfindung realisierbar.

Die oberen Enden 44 und 46 von Stellglied 36 und von den Stützen 38 sind an der Versteifungsplatte 28 befestigt. Sie stützen sich an ihren unteren Enden 48 bzw. 50 im Gehäuse 12 ab, was in den Figuren lediglich angedeutet ist. Beispielsweise könnten sich die besagten Elemente an einer Quertraverse, die sich parallel zum Display 16 im Gehäuse erstreckt, abgestützt sein.

Innerhalb des Gehäuses 12 befindet sich eine Führungseinrichtung 52, die beidseitig der Lateralränder 54 des Display 16 angeordnet ist und dafür sorgt, dass das flexible Display 16 beim Ein- und Ausfahren längs einer Krümmungslinie 56 um etwa 90 Grad umgelenkt wird.

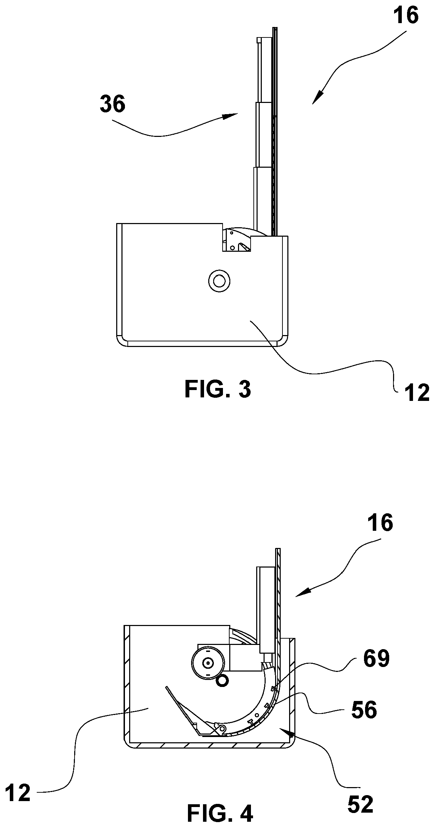

Die Fign. 1 bis 3 zeigen die Anzeigevorrichtung 10 im vollständig ausgefahrenen Zustand ihres Display 16, und zwar in verschiedenen Ansichten, während die Fign. 4 und 5 die Anzeigevorrichtung 10 im vollständig eingefahren Zustand des Display 16 zeigen. Zu erkennen ist, dass das Display 16 im eingefahrenen Zustand nicht vollständig in das Gehäuse 12 abgetaucht ist, sondern aus der nicht gezeigten Öffnung an der Oberseite 14 des Display 16 herausschaut.

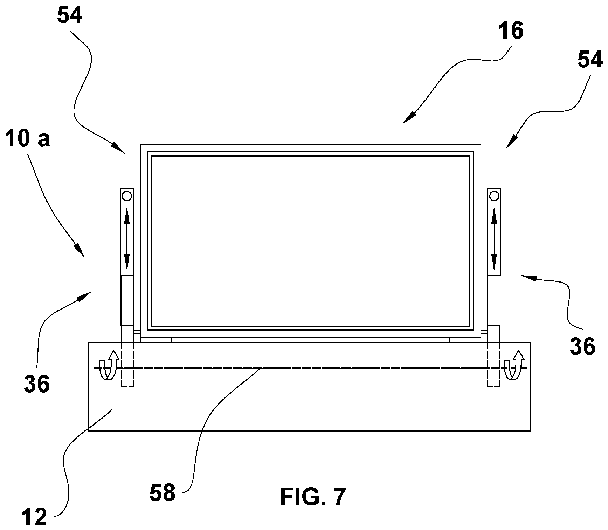

In den Fign. 7 bis 11 sind teilweise schematisch zwei weitere Ausführungsbeispiele von aus- und einfahrbaren Anzeigevorrichtungen 10a, 10b gezeigt. Die Konstruktionen dieser Ausführungsbeispiele erlauben das vollständige Verstauen des Display 16 in dem Gehäuse 12.

Hierzu ist gemäß Fig. 7 das Display 16 zwischen zwei motorisch ausfahrbaren Stellgliedern 36 angeordnet, die längs der Lateralränder 54 des Display 16 angeordnet sind. Die linearen Doppelpfeile deuten das Aus- und Einfahren der Stellglieder 36 an, die an ihren unteren Enden um die Schwenkachse 58 im Gehäuse 12 schwenkbar gelagert sind. Im maximal eingezogenen Zustand des Display 16 ergibt sich eine ähnliche Situation wie in den Fign. 4 und 5 gezeigt. Das dann noch nach oben überstehende obere Ende des Display 16 kann durch Verschwenken der eingezogenen Stellglieder 36 in das Gehäuse 12 hineingekippt werden.

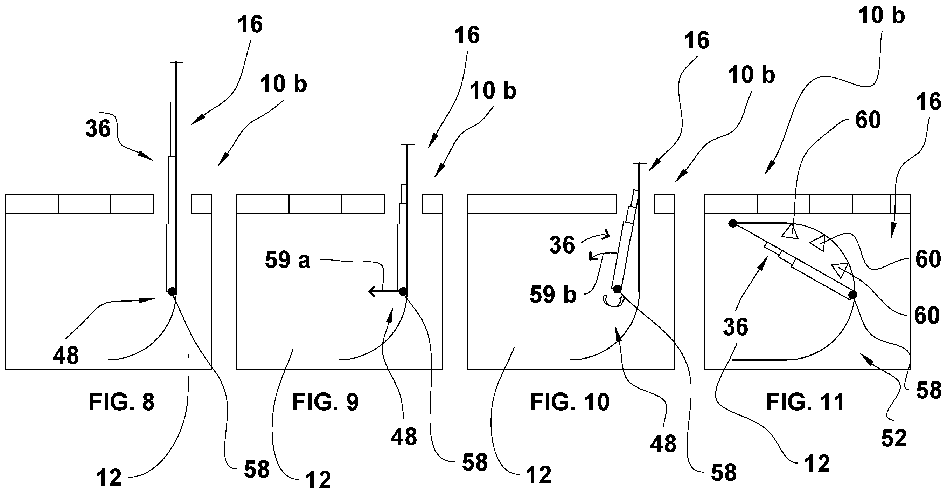

In den Fign. 8 bis 11 ist schematisch gezeigt, wie dieses Einklappen realisiert werden kann, wenn sich das Stellglied 36 und die ggf. vorhandenen Stützen 38 hinter dem Display 16 befinden, wie es auch im Ausführungsbeispiel der Anzeigevorrichtung 10 gezeigt ist. Fig. 8 zeigt das Display im vollständig ausgefahrenen Zustand. Das Stellglied 36 ist symbolisiert dargestellt. Fig. 9 zeigt die Situation, in der das Stellglied 36 maximal eingefahren ist. Um nun den überstehenden Bereich des Display 16 in das Gehäuse 12 einklappen zu können, muss zunächst das untere Ende 48 des Stellgliedes 36 vom Display 16 abgerückt werden (siehe Pfeil 59a), da ansonsten die Gefahr besteht, dass beim Verschwenken des Stellglied 36 es zu einem Knicken des Display 16 kommt. Nach dem Abrücken des unteren Endes 48 ergibt sich die Situation gemäß Fig. 10. Nun kann das Stellglied 36 von oben in das Gehäuse 12 eingeschwenkt werden (siehe Pfeil 59b), wozu die Oberseite 14 durch eine Blendenkonstruktion odgl. geöffnet werden kann, so dass sich die Situation gemäß Fig. 11 ergibt. Anlageelemente 60 sorgen dafür, dass das Display 16 in seinem oberen Bereich eine definierte Krümmung erfährt, wenn es, wie in Fig. 11 gezeigt, vollständig in das Gehäuse 12 eingeklappt ist.

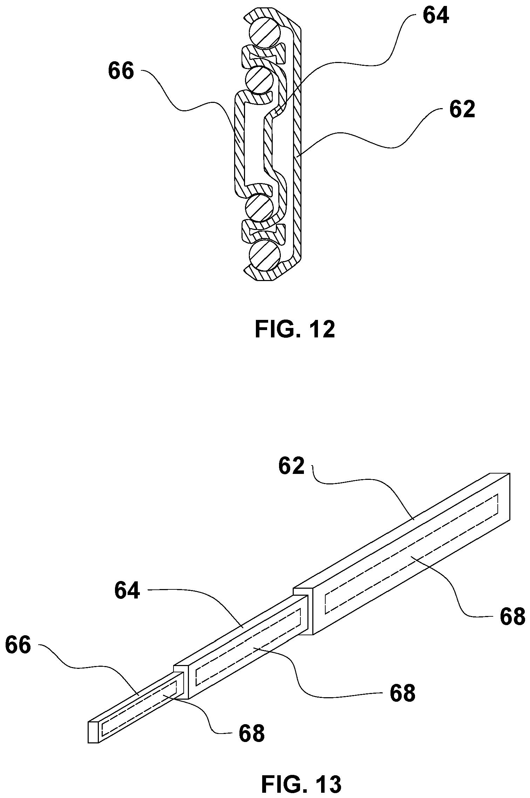

Die Fign. 12 und 13 zeigen zwei Ansichten einer Teleskop- bzw. Längenveränderbarkeitskonstruktion für sowohl das Stellglied 36 als auch die Stützen 38 (in Fig. 13 ist diese Konstruktion lediglich schematisch gezeigt). Beide Elemente sind in den hier beschriebenen Ausführungsbeispielen mit drei Stützglied- bzw. Stützelementen 62, 64, 66 versehen, die, wie in Fig. 12 gezeigt, jeweils im Wesentlichen C-förmig als Profilelemente ausgebildet und aneinander geführt sind, wobei die Linearführung mittels Kugellager realisiert ist. Der Vorteil der Konstruktion gemäß Fig. 12 besteht darin, dass die Konstruktion flachbauend ist. In Fig. 13 ist in jedem Profilelement 62, 64, 66 ein Schlitz 68 gezeigt, in den beim Ausfahren pilzkopfähnliche Halteelemente 69 eintauchen, die an der Rückseite des Displayfolienträgers 24 von diesem abstehen. Hierdurch wird das Display 16 im ausgefahrenen Zustand an dem Stellglied 36 bzw. an den Stützen 38 fixiert und an einem ungewollten Abrücken von diesen Elementen gehindert.

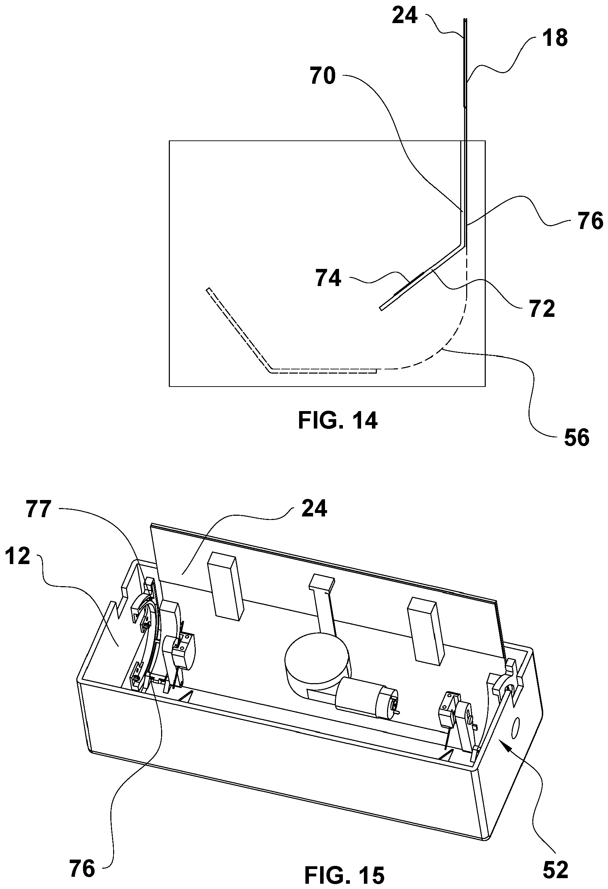

In Fig. 14 ist eine alternative Ausgestaltung des Displayfolienträgers 24 gezeigt, der in seinem unteren Bereich eine Versteifungszone 70 aufweist, von der ein plattenförmiges Trägerelement 72 absteht, an dem eine Platine 74 gehalten ist, die Elektronik für die Ansteuerung der Pixel der Displayfolie 18 aufweist. Von der Versteifungszone 70 stehen lateralseitig Führungsstifte 76 ab, die in Führungsschlitze 77 der Führungseinrichtung 52 eintauchen, um den unteren Bereich des Displayfolienträgers 24 längs der Krümmungslinie 56 innerhalb des Gehäuses 12 umzulenken (siehe auch Fig. 15).

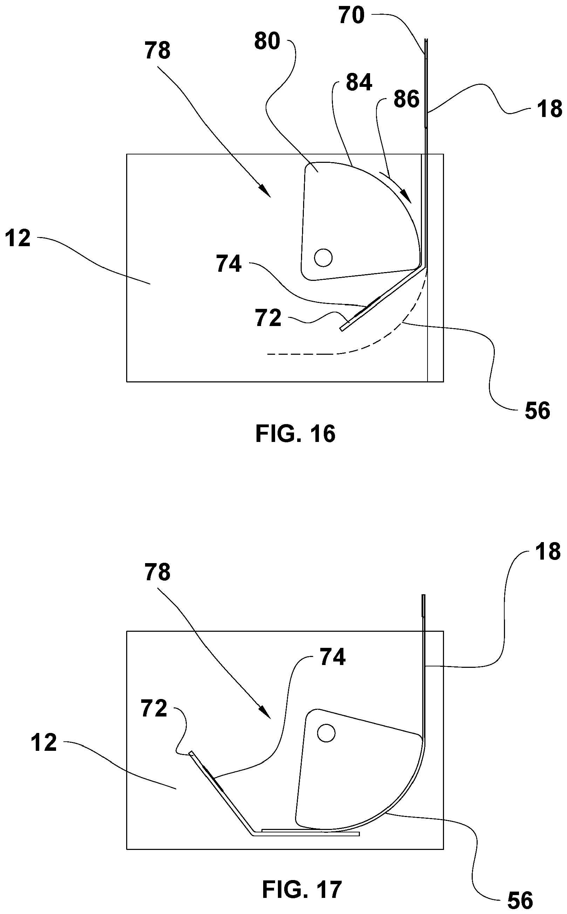

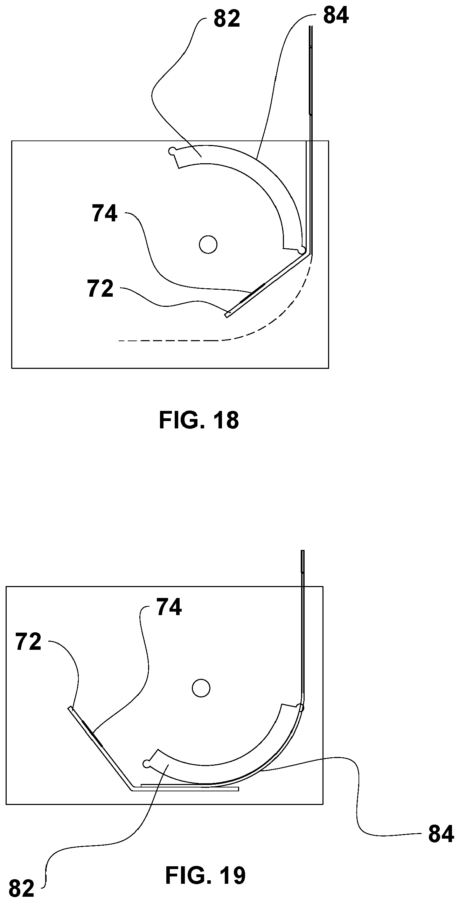

Die Aufrechterhaltung der Krümmung des Displayfolienträgers 24 längs der Krümmungslinie 56 wird unterstützt durch zwei Führungskörper 78, die entweder als Teilscheibenkörper 80 (siehe die Fign. 16 und 17) oder als Teilringkörper 82 (siehe die Fign. 18 und 19) ausgebildet sind und jeweils einen gekrümmten Außenrand 84 aufweisen. Die Führungskörper 78 sind in Richtung der Pfeile 86 der Fign. 16 bzw. 18 vorgespannt und unterstützen neben der Beibehaltung der Krümmung des Displayfolienträgers 24 und der Displayfolie 18 auch deren Einzug in das Gehäuse 12, wenn das Stellglied 36 eingefahren wird.

In den Fign. 16 und 18 ist der jeweilige Führungskörper 78 in seiner vorgespannten Position gezeigt, in der das Display 16 vollständig ausgefahren ist. Wird nun das Stellglied 36 eingefahren, so verschwenkt der betreffende Führungskörper 78 in Richtung des Pfeils 86, wobei er mit seinem gekrümmten Außenrand 84 in Anlage mit den Lateralrändern des Displayfolienträgers 24 gelangt und dessen Krümmung definiert und unterstützt. In der maximal eingefahrenen Position des Display 16 (siehe die Fign. 17 und 19) nimmt der betreffende Führungskörper 78 dann die in der betreffenden Figur gezeigte Position ein.

Die Führungskörper 78 wirken durch Mitnehmerelemente in Form beispielsweise von Mitnehmerstiften mit insbesondere den Lateralrändern des Displayfolienträgers 24 zusammen, um eine mechanische Kopplung zwischen beiden zu realisieren, so dass sie das Einziehen von Displayfolienträger 24 und Displayfolie 18 in das Gehäuse 12 unterstützen können.

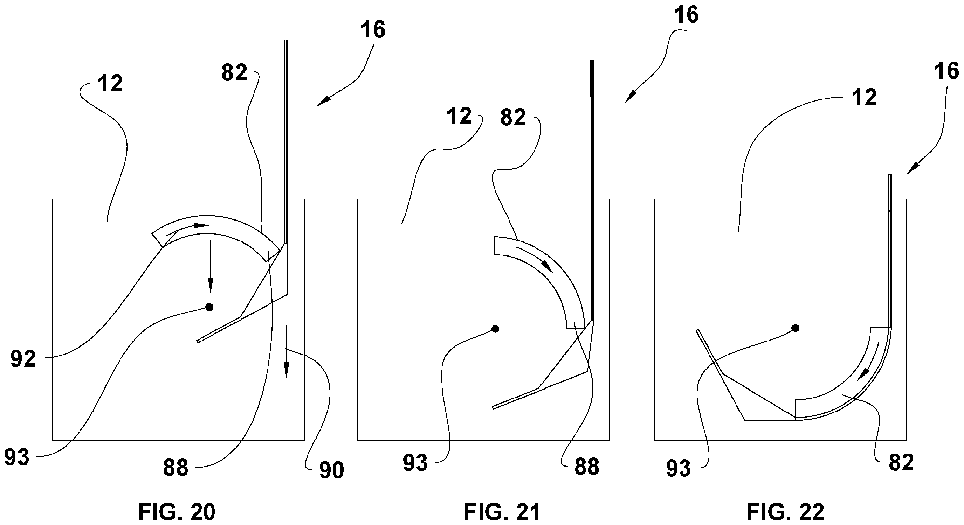

In den Fign. 20 bis 22 ist schematisch gezeigt, wie die in diesem Ausführungsbeispiel als Teilringkörper 82 ausgebildeten Führungskörper 78 um ihr mit dem Displayfolienträger 24 zusammenwirkendes Mitnehmerelement 88 schwenkbar sind. In Fig. 20 ist die maximal ausgefahrene Position des Display 16 gezeigt. Die Teilringkörper 82 sind nach oben geschwenkt gezeigt. In einer ersten Phase des Einzugs des Display 16 wird dieses, wie durch den Linearpfeil 90 angedeutet, nach unten bewegt, womit sich auch die Teilringkörper 82 linear nach unten bewegen. Dabei verschwenken die Teilringkörper 82 zusätzlich um ihre Mitnehmerenden 88 in Richtung des Pfeils, vollführen also eine Überlagerungsbewegung aus Linearbewegung und Drehbewegung um den Drehpunkt 93, der sich also auch lateral nach unten verschiebt. Es ergibt sich dann die Situation gemäß Fig. 21. Ausgehend von dieser Situation erfolgt dann der weitere Einzug des Display 16 bzw. dessen Einzugunterstützung so, wie in den Fign. 18 und 19 gezeigt, so dass sich schließlich im maximal eingezogenen Zustand des Display 16 die Situation gemäß Fig. 22 ergibt.

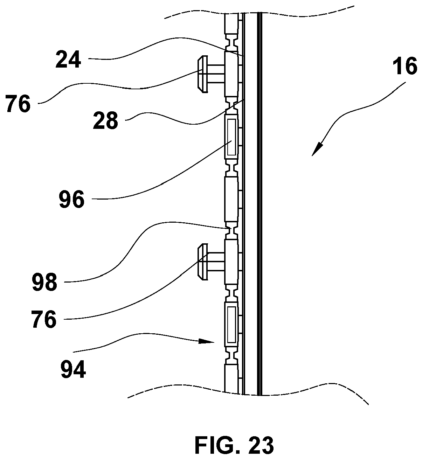

In Fig. 23 ist angedeutet, dass das Display 16 durch Versteifungslamellen 94 weiter versteift sein kann. Die einzelnen Lamellen 94 können kunststoffumspritzte Kerne 96 aufweisen, wobei das Kunststoffmaterial zwischen benachbarten Lamellen 94 als Filmscharniere 98 ausgestaltet ist. Die einzelnen Lamellen 94 sind durch schmale Klebestreifen 100 mit dem Displayfolienträger 24 klebend verbunden. Die gelenkige Verbindung der Lamellen 94 untereinander kann auch auf andere Art und Weise als durch Filmscharniere 98 aus beispielsweise Kunststoff realisiert sein. Beispielsweise eignen sich hier auch rein mechanisch arbeitende Gelenke mit Gelenkachsen.

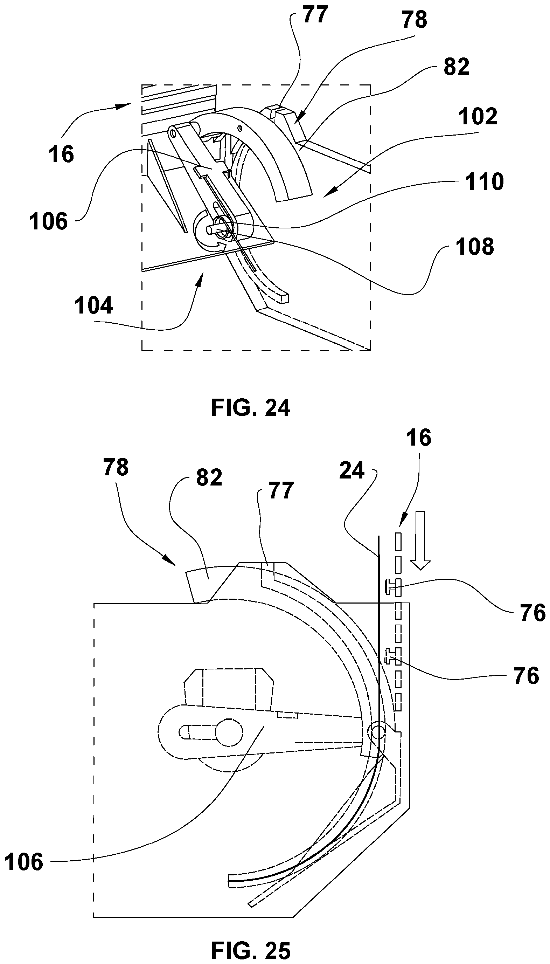

Schließlich zeigen die Fign. 24 und 25 noch einen Vorspannmechanismus, um die Führungskörper 78 in die in den Fign. 18 und 20 gezeigten Positionen federnd vorzuspannen, und zwar mit einer in Richtung der Pfeile 86 wirkenden Vorspanneinheit 102. Die Vorspanneinheit 102 weist einen Federmechanismus 104 auf, der einen Antriebshebel 106 umfasst, und zwar pro Führungskörper 78. Der Antriebshebel 106 ist drehbar um eine Drehachse 108 gelagert, an der eine Spannfeder 110 angeordnet ist. Der Antriebshebel 106 ist mit dem Führungskörper 78 gekoppelt und wird mit diesem zum Spannen der Spannfeder 110 mitbewegt, wenn das Display 16 ausgefahren wird, was wiederum durch Antrieb des Stellgliedes 36 erfolgt. Im ausgefahrenen Zustand, in dem die Führungskörper 78 die Positionen gemäß den Fign. 16 bzw. 18 einnehmen, ist dann die Spannfeder 110 gespannt, so dass sie beim Einfahren des Stellglieds 36 den Einzugs des Display 16 unterstützen, indem sie die Führungskörper 78 mitdrehen.

### BEZUGSZEICHENLISTE

- 10: Anzeigevorrichtung
- 10a: Anzeigevorrichtung
- 10b: Anzeigevorrichtung
- 12: Gehäuse
- 14: Oberseite des Gehäuses
- 16: Display
- 18: OLED-Displayfolie
- 20: Anzeigefläche
- 22: Abdeckfilm
- 24: Displayfolienträger
- 26: oberer Endabschnitt des Displayfolienträgers
- 28: Versteifungsplatte
- 30: Hauptabschnitt des Displayfolienträgers
- 32: oberer Endabschnitt der Displayfolie
- 34: Hauptabschnitt der Displayfolie
- 36: Stellglied
- 38: Stütze
- 40: Motor
- 42: Getriebe
- 44: oberes Ende des Stellglieds
- 46: oberes Ende der Stütze
- 48: untere Ende des Stellglieds
- 50: untere Ende der Stütze
- 52: Führungseinrichtung
- 54: Lateralränder des Displayfolienträgers
- 56: Krümmungslinie
- 58: Schwenkachse des Stellglieds bzw. der Stütze
- 59a: Linearpfeil
- 59b: Drehpfeil
- 60: Anlageelement
- 62: Profilelement von Stellglied bzw. Stütze
- 64: Profilelement von Stellglied bzw. Stütze
- 66: Profilelement von Stellglied bzw. Stütze
- 68: Aufnahmeschlitz von Stellglied bzw. Stütze
- 69: Halteelement
- 70: Versteifungszone
- 72: Trägerelement
- 74: Platine
- 76: Führungsstifte der Führungseinrichtung
- 77: Führungsschlitze der Führungseinrichtung
- 78: Führungskörper der Führungseinrichtung
- 80: Teilscheibenkörper
- 82: Teilringkörper
- 84: Außenrand des Führungskörpers
- 86: Pfeile
- 88: Mitnehmerende des Führungskörpers
- 90: Pfeil für Linearbewegungsrichtung des Displays
- 92: Pfeil für Schwenk-/Dreh-Bewegungsrichtung des Teilringkörpers
- 93: Drehpunkt des Teilringkörpers
- 94: Versteifungslamelle
- 96: Kern der Versteifungslamelle
- 98: Filmscharniere zwischen Versteifungslamellen
- 100: Klebestreifen
- 102: Vorspanneinheit
- 104: Federmechanismus der Vorspanneinheit
- 106: Antriebshebel der Vorspanneinheit
- 108: Drehachse
- 110: Spannfeder

## Patentansprüche

1. Aus- und einfahrbare Anzeigevorrichtung für ein Fahrzeug, mit
- einer flexiblen Displayfolie (18) in OLED-Technologie, die eine eine Anzeigefläche (20) aufweisende Vorderseite sowie eine Rückseite und einen oberen Endabschnitt (32) aufweist, an den sich ein sich bis zu einem unteren Ende der Displayfolie (18) erstreckender Hauptabschnitt (34) der Displayfolie (18) anschließt,
- einem flexiblen Displayfolienträger (24), der an der Rückseite der Displayfolie (18) an dieser befestigt oder mit dieser vermittels einer Zwischenschicht aus insbesondere elastischem Material verbunden ist sowie versehen ist mit einem oberen Endabschnitt (26), an den sich ein sich bis zu einem unteren Ende des Displayfolienträgers (24) erstreckender Hauptabschnitt (30) des Displayfolienträgers (24) anschließt, wobei der obere Endabschnitt (26) des Displayfolienträgers (24) an dem oberen Endabschnitt (32) der Displayfolie (18) anliegt,
- einem Gehäuse (12), in das die Displayfolie (18) mitsamt dem Displayfolienträger (24) einfahrbar und aus dem die Displayfolie (18) mitsamt dem Displayfolienträger (24) ausfahrbar ist, und
- mindestens einem motorisch antreibbaren, längenveränderbaren Stellglied (36), das ein sich im und/oder am Gehäuse (12) abstützendes erstes Ende (48) und ein zweites Ende (44) aufweist, an dem der obere Endabschnitt (26) des Displayfolienträgers (24) befestigt ist,
**dadurch gekennzeichnet,**
- **dass** der obere Endabschnitt (26) des Displayfolienträgers (24) versteift ist und
- **dass** eine Führungseinrichtung (52) in dem Gehäuse (12) vorgesehen istzur Führung von Displayfolie (18) und Displayfolienträger (24) in zumindest einem Teilbereich von deren Hauptabschnitten (34, 30) entlang einer Krümmungslinie (56) über weniger als 180 Grad oder weniger als 135 Grad oder weniger als 90 Grad bei einem durch Längenveränderung des mindestens einen Stellglieds (36) erfolgenden Aus- und Einfahren von zumindest Teilbereichen der Hauptabschnitte (34, 30) von Displayfolie (18) und Displayfolienträger (24) aus dem und in das Gehäuse (12).

2. Aus- und einfahrbare Anzeigevorrichtung nach Anspruch 1, **dadurch gekennzeichnet, dass** das mindestens eine Stellglied (36) mindestens zwei zwischen den beiden Enden angeordnete Stellgliedelemente (62, 64, 66) aufweist, wobei jeweils benachbarte Stellgliedelemente (62, 64, 66) aneinander und/oder ineinander verschiebbar geführt sind.

3. Aus- und einfahrbare Anzeigevorrichtung nach Anspruch 2, **dadurch gekennzeichnet, dass** das Stellglied (36) ein im Wesentlichen C-förmiges, mit einer geschlossenen Seite und einer offenen Seite versehenes, erstes Stellglied-Profilelement, ein verschiebbar im ersten Stellglied-Profilelement geführtes, ebenfalls im Wesentlichen C-förmiges, mit einer geschlossenen Seite und einer offenen Seite versehenes, zweites Stellglied-profilelement, dessen geschlossene Seite der geschlossenen Seite des ersten Stellgliedprofilelements zugewandt ist, und ein verschiebbar im zweiten Stellgliedprofilelement geführtes, im Wesentlichen C-förmiges, mit einer geschlossenen Seite und einer offenen Seite versehenes, drittes Stellgliedprofilelement aufweist, dessen geschlossene Seite die offene Seite des zweiten Stellgliedprofilelements überdeckt.

4. Aus- und einfahrbare Anzeigevorrichtung nach einem der Ansprüche 1 bis 3, **gekennzeichnet durch** mindestens eine längenveränderbare Stütze (38) mit einem sich im Gehäuse (12) abstützenden ersten Ende (50) und einem zweiten Ende (46), an dem der obere Endbereich (26) des Displayfolienträgers (24) befestigt ist.

5. Aus- und einfahrbare Anzeigevorrichtung nach Anspruch 4, **dadurch gekennzeichnet, dass** die mindestens eine Stütze (38) mindestens zwei zwischen den beiden Enden angeordnete Stützelemente aufweist, wobei jeweils benachbarte Stützelemente aneinander und/oder ineinander verschiebbar geführt sind.

6. Aus- und einfahrbare Anzeigevorrichtung nach Anspruch 5, **dadurch gekennzeichnet, dass** die Stütze (38) ein im Wesentlichen C-förmiges, mit einer geschlossenen Seite und einer offenen Seite versehenes, erstes Stützprofilelement, ein verschiebbar im ersten Stützprofilelement geführtes, ebenfalls im Wesentlichen C-förmiges, mit einer geschlossenen Seite und einer offenen Seite versehenes, zweites Stützprofilelement, dessen geschlossene Seite der geschlossenen Seite des ersten Stützprofilelements zugewandt ist, und ein verschiebbar im zweiten Stützprofilelement geführtes, im Wesentlichen C-förmiges, mit einer geschlossenen Seite und einer offenen Seite versehenes, drittes Stützprofilelement aufweist, dessen geschlossene Seite die offene Seite des zweiten Stützprofilelements überdeckt.

7. Aus- und einfahrbare Anzeigevorrichtung nach einem der Ansprüche 1 bis 6, **dadurch gekennzeichnet, dass** das mindestens eine Stellglied (36) oder zumindest eines seiner Stützelemente und/oder, sofern vorhanden, die mindestens eine Stütze (38) oder zumindest eines ihrer Stützelemente eine dem Displayfolienträger (24) zugewandte Innenseite aufweist, an der eine Aufnahmenut ausgebildet oder angeordnet ist, dass abstehend von der der Displayfolie (18) abgewandten Rückseite des Displayfolienträgers (24) in dessen Hauptabschnitt (30) mindestens ein Halteelement (69) angeordnet ist, und zwar auf einer gedachten Linie, die beim Aus- und Einfahren von Displayfolie (18) und Displayfolienträger (24) der Aufnahmenut gegenüberliegt, und dass das mindestens eine Halteelement (69) beim Ausfahren von Displayfolie (18) und Displayfolienträger (24) in die Aufnahmenut eintaucht und sich beim Einfahren von Displayfolie (18) und Displayfolienträger (24) aus der Aufnahmenut herausbewegt.

8. Aus- und einfahrbare Anzeigevorrichtung nach Anspruch 7, **dadurch gekennzeichnet, dass** das mindestens eine Halteelement (69) ein dem Displayfolienträger (24) abgewandtes verbreitertes oder abgewinkelt ausgebildetes Ende zum Hintergreifen eines Aufnahmeschlitzes (68) der Aufnahmenut aufweist.

9. Aus- und einfahrbare Anzeigevorrichtung nach einem der Ansprüche 1 bis 8, **dadurch gekennzeichnet, dass** die Displayfolie (18) und der Displayfolienträger (24) im in das Gehäuse (12) eingefahrenen Zustand mit ihren oberen Endabschnitten (32, 26) zumindest teilweise aus dem Gehäuse (12) herausragen.

10. Aus- und einfahrbare Anzeigevorrichtung nach einem der Ansprüche 1 bis 9, **dadurch gekennzeichnet, dass** das mindestens eine Stellglied (36) und, sofern vorhanden, die mindestens eine Stütze (38) zum Einschwenken der oberen Endabschnitte (32, 26) von Displayfolie (18) und Displayfolienträger (24) im eingefahrenen Zustand in das Gehäuse (12) an dem jeweiligen ersten Ende im Gehäuse (12) schwenkbar gelagert ist oder sind.

11. Aus- und einfahrbare Anzeigevorrichtung nach Anspruch 10, **dadurch gekennzeichnet, dass** das zweite Ende (44) des Stellglieds (36) und, sofern vorhanden, das zweite Ende (46) der mindestens einen Stütze (38) gelenkig oder biegbar an dem oberen Endabschnitt (26) des Displayfolienträgers (24) angeordnet ist.

12. Aus- und einfahrbare Anzeigevorrichtung nach einem der Ansprüche 10 oder 11, **dadurch gekennzeichnet, dass** das erste Ende (48) des mindestens einen Stellglieds (36) und, sofern vorhanden, das erste Ende (50) der mindestens einen Stütze (38) im eingefahrenen Zustand von Displayfolie (18) und Displayfolienträger (24) von der Rückseite des Displayfolienträgers (24) abrückbar und in der abgerückten Position in das Gehäuse (12) einschwenkbar ist bzw. sind, wobei insbesondere im eingeschwenkten Zustand der Krümmungsgrad des an den oberen Endabschnitt angrenzenden Teilbereichs des Hauptabschnitts von Displayfolie (18) und Displayfolienträger (24) durch im Gehäuse (12) angeordnete Anlageelemente (60) definiert ist.

13. Aus- und einfahrbare Anzeigevorrichtung nach einem der Ansprüche 1 bis 12, **gekennzeichnet durch** zwei Stellglieder (36), die beidseitig von Displayfolie (18) und Displayfolienträger (24) angeordnet und mit dem oberen Endabschnitt (26) des Displayfolienträgers (24) verbunden sind.

14. Aus- und einfahrbare Anzeigevorrichtung nach einem der Ansprüche 1 bis 12, **gekennzeichnet durch** ein Stellglied (36) und eine Stütze (38), die beidseitig von Displayfolie (18) und Displayfolienträger (24) angeordnet und mit dem oberen Endabschnitt (26) des Displayfolienträgers (24) verbunden sind.

15. Aus- und einfahrbare Anzeigevorrichtung nach einem der Ansprüche 1 bis 14, **dadurch gekennzeichnet, dass** die Führungseinrichtung (52) zwei einander gegenüberliegenden Führungsschlitze (77) aufweist und dass der Displayfolienträger (24) längs seines Hauptabschnitts (30) verlaufende Lateralränder (54) aufweist, von denen zum Führen des Displayfolienträgers (24) mit dem Führungsschlitz (77) zusammenwirkende Führungsstifte (76) lateral ab- oder überstehen.

16. Aus- und einfahrbare Anzeigevorrichtung nach einem der Ansprüche 1 bis 15, **dadurch gekennzeichnet, dass** der Displayfolienträger (24) an seinem dem oberen Endabschnitt (26) abgewandten Ende seines Hauptabschnitts (30) mit einer Versteifungszone (70) versehen ist.

17. Aus- und einfahrbare Anzeigevorrichtung nach Anspruch 16, **dadurch gekennzeichnet, dass** die Führungsstifte (76) im Bereich der Versteifungszone (70) des Hauptabschnitts (30) des Displayfolienträgers (24) angeordnet sind.

18. Aus- und einfahrbare Anzeigevorrichtung nach Anspruch 16 oder 17, **dadurch gekennzeichnet, dass** von der Versteifungszone (70) ein Trägerelement (72) mit einer starren oder flexiblen Leiterplatine (74) abgewinkelt absteht.

19. Aus- und einfahrbare Anzeigevorrichtung nach einem der Ansprüche 1 bis 18, **dadurch gekennzeichnet, dass** die Führungseinrichtung (52) zwei einander gegenüberliegende Führungskörper (78) aufweist, die drehbar gelagert sind und jeweils einen gekrümmten Außenrand (84) aufweisen, und dass die Führungskörper (78) beim Ein- und Ausfahren von Displayfolie (18) und Displayfolienträger (24) verschwenken und dabei den Displayfolienträger (24) lateralrandseitig stützen.

20. Aus- und einfahrbare Anzeigevorrichtung nach Anspruch 19, **dadurch gekennzeichnet, dass** die Führungskörper (78) zum beim Einfahren von Displayfolie (18) und Displayfolienträger (24) erfolgenden Mitnehmen des Displayfolienträgers (24) mit diesem mechanisch gekoppelt sind.

21. Aus- und einfahrbare Anzeigevorrichtung nach Anspruch 19 oder 20, **dadurch gekennzeichnet, dass** die Führungskörper (78) als Teilscheibenkörper (80) ausgebildet sind, die sich über einen Winkel von weniger als 180 Grad oder weniger als 135 Grad oder weniger als 90 Grad erstrecken.

22. Aus- und einfahrbare Anzeigevorrichtung nach Anspruch 19 oder 20, **dadurch gekennzeichnet, dass** die Führungskörper (78) als Teilringkörper (82) ausgebildet sind, die sich über einen Winkel von weniger als 180 Grad oder weniger als 135 Grad oder weniger als 90 Grad erstrecken.

23. Aus- und einfahrbare Anzeigevorrichtung nach einem der Ansprüche 19 bis 22, **dadurch gekennzeichnet, dass** jeder Führungskörper (78) ein Mitnehmerende (88) zum Mitnehmen des Displayfolienträgers (24) aufweist.

24. Aus- und einfahrbare Anzeigevorrichtung nach Anspruch 23, **dadurch gekennzeichnet, dass** an dem Mitnehmerende (88) jedes Führungskörpers (78) ein lateralrandseitig des Displayfolienträgers (24) überstehender Mitnehmerstift angeordnet ist, der in eine Stiftaufnahme an dem Displayfolienträger (24) eintaucht.

25. Aus- und einfahrbare Anzeigevorrichtung nach Anspruch 19 und 24, 21 , **dadurch gekennzeichnet, dass** die Mitnehmerstifte der Führungskörper (78) als Führungsstifte (76) in die Führungsschlitze (77) der Führungseinrichtung (52) eingetaucht sind.

26. Aus- und einfahrbare Anzeigevorrichtung nach einem der Ansprüche 23 bis 25, **dadurch gekennzeichnet, dass** jeder Führungskörper (78) an seinem Mitnehmerende (88) zum Einschwenken in das Gehäuse (12) drehbar gelagert ist, wobei die Drehachse quer zur Ein- und Ausfahrrichtung von Displayfolie (18) und Displayfolienträger (24) verläuft.

27. Aus- und einfahrbare Anzeigevorrichtung nach einem der Ansprüche 1 bis 26, **dadurch gekennzeichnet, dass** die Führungseinrichtung (52) eine Vorspanneinheit (102) zum automatischen Einfahren von Displayfolie (18) und Displayfolienträger (24) oder zumindest zum Unterstützen eines automatischen Einfahrens von Displayfolie (18) und Displayfolienträger (24) aufweist, wobei die Vorspanneinheit (102) beim Ausfahren des mindestens einen Stellgliedes (36) spannbar ist und beim zum Einfahren von Displayfolie (18) und Displayfolienträger (24) erfolgenden Einfahren des mindestens einen Stellglieds (36) entspannbar ist.

28. Aus- und einfahrbare Anzeigevorrichtung nach Anspruch 27, **dadurch gekennzeichnet, dass** die Vorspanneinheit (102) mindestens einen Antriebshebel (106) mit Drehlager und einem Federspannmechanismus (104) z. B. mit einer Schenkel-, Spiral- oder Schraubenfeder an seinem Drehlager aufweist und dass der mindestens eine Antriebshebel (106) mit einem der Führungskörper (78) mechanisch gekoppelt ist.

29. Aus- und einfahrbare Anzeigevorrichtung nach Anspruch 27, **dadurch gekennzeichnet, dass** die Vorspanneinheit (102) zwei Antriebshebel (106) aufweist, die jeweils mit einem anderen der Führungskörper (78) mechanisch gekoppelt sind.

30. Aus- und einfahrbare Anzeigevorrichtung nach einem der Ansprüche 1 bis 29, **dadurch gekennzeichnet, dass** an der der Displayfolie (18) abgewandten Rückseite des Displayfolienträgers (24) ein Versteifungslamellen (94) aufweisender Versteifungsträger angeordnet ist, dessen quer zur Ein- und Ausfahrrichtung von Displayfolie (18) und Displayfolienträger (24) verlaufende Verstärkungslamellen (94) entlang von streifenförmigen Bereichen an dem Displayfolienträger (24) befestigt sind und dass das mindestens eine Halteelement (69), sofern vorhanden, an einer der Versteifungslamellen (94) oder dass mehrere Halteelemente (69), sofern vorhanden, an verschiedenen der Versteifungslamellen (94) angeordnet sind.

## Claims

1. An extendable and retractable display device for a vehicle, comprising
- a flexible display foil (18) in OLED technology comprising a front side having a display surface (20) and a rear side and an upper end portion (32) adjoined by a main portion (34) of the display foil (18) extending to a lower end of the display foil (18),
- a flexible display foil carrier (24) being attached to the display foil (18) at the rear side thereof or being connected thereto by means of an intermediate layer of, in particular, elastic material and being provided with an upper end portion (26), which is adjoined by a main portion (30) of the display foil carrier (24) extending to a lower end of the display foil carrier (24), wherein the upper end portion (26) of the display foil carrier (24) abuts against the upper end portion (32) of the display foil (18),
- a housing (12) into which the display foil (18) together with the display foil carrier (24) is retractable and out of which the display foil (18) together with the display foil carrier (24) is extendable,
- at least one motorically drivable, length-variable actuator (36) having a first end (48) supported in and/or on the housing (12) and a second end (44) to which the upper end portion (26) of the display foil carrier (24) is attached,
**characterized in that**
- the upper end portion (26) of the display foil carrier (24) is stiffened, and
- a guiding means (52) is provided in the housing (12) for guiding the display foil (18) and the display foil carrier (24) in at least a partial area of their main portions (34, 30) along a line of curvature (56) over less than 180 degrees or less than 135 degrees or less than 90 degrees during an extension and retraction of at least partial areas of the main portions (34, 30) of the display foil (18) and the display foil carrier (24) out of and into the housing (12) by changing the length of the at least one actuator (36).

2. The extendable and retractable display device according to claim 1, **characterized in that** at least one actuator (36) has at least two actuator elements (62, 64, 66) arranged between the two ends, wherein neighboring actuator elements (62, 64, 66) are respectively guided so as to be slidable against and/or into one another.

3. The extendable and retractable display device according to claim 2, **characterized in that** the actuator (36) comprises a substantially C-shaped first actuator profile element provided with a closed side and an open side, a second actuator profile element which is slidably guided in the first actuator profile element, is also substantially C-shaped, and is provided with a closed side and an open side, the closed side of which faces the closed side of the first actuator profile element, and a third actuator profile element which is slidably guided in the second actuator profile element, is substantially C-shaped, and is provided with a closed side and an open side, the closed side of which covers the open side of the second actuator profile element.

4. The extendable and retractable display device according to any one of claims 1 to 3, **characterized by** at least one length-variable support (38) having a first end (50) supported in the housing (12) and a second end (46) to which the upper end area (26) of the display foil carrier (24) is attached.

5. The extendable and retractable display device according to claim 4, **characterized in that** the at least one support (38) has at least two support elements arranged between the two ends, wherein neighboring support elements are respectively guided so as to be slidable against and/or into one another.

6. The extendable and retractable display device according to claim 5, **characterized in that** the support (38) comprises a substantially C-shaped first support profile element provided with a closed side and an open side, a second support profile element which is slidably guided in the first support profile element, is also substantially C-shaped and is provided with a closed side and an open side, the closed side of which faces the closed side of the first support profile element, and a third support profile element, which is slidably guided in the second support profile element, is substantially C-shaped, and is provided with a closed side and an open side, the closed side of which covers the open side of the second support profile element.

7. The extendable and retractable display device according to any one of claims 1 to 6, **characterized in that** the at least one actuator (36) or at least one of its support elements and/or, if present, the at least one support (38) or at least one of its support elements has an inner side facing the display foil carrier (24), on which inner side a receiving groove is formed or arranged, that at least one retaining element (69) is arranged, protruding from the rear side of the display foil carrier (24) facing away from the display foil (18), in the main portion (30) of said display foil carrier (24), specifically on an imaginary line which is opposite the receiving groove when the display foil (18) and the display foil carrier (24) are extended and retracted, and that the at least one retaining element (69) immerses into the receiving groove when the display foil (18) and the display foil carrier (24) are extended and moves out of the receiving groove when the display foil (18) and display foil carrier (24) are retracted.

8. The extendable and retractable display device according to claim 7, **characterized in that** the at least one retaining element (69) has a widened or angled end facing away from the display foil carrier (24) for engaging behind a receiving slot (68) of the receiving groove.

9. The extendable and retractable display device according to any one of claims 1 to 8, **characterized in that** the display foil (18) and the display foil carrier (24) at least partially protrude from the housing (12) with their upper end portions (32, 26) when being retracted into the housing (12).

10. The extendable and retractable display device according to any one of claims 1 to 9, **characterized in that** the at least one actuator (36) and, if present, the at least one support (38) for pivoting in the upper end portions (32, 26) of the display foil (18) and the display foil carrier (24) in the retracted state into the housing (12) is or are pivotably mounted at the respective first end in the housing (12).

11. The extendable and retractable display device according to claim 10, **characterized in that** the second end (44) of the actuator (36) and, if present, the second end (46) of the at least one support (38) is arranged at the upper end portion (26) of the display foil carrier (24) in an articulated or bendable manner.

12. The extendable and retractable display device according to any one of claims 10 or 11, **characterized in that** the first end (48) of the at least one actuator (36) and, if present, the first end (50) of the at least one support (38) can be moved away from the rear side of the display foil carrier (24) in the retracted state of the display foil (18) and the display foil carrier (24) and can be pivoted into the housing (12) in the moved-away position, wherein, in particular in the pivoted state, the degree of curvature of the partial area of the main portion of the display foil (18) and the display foil carrier (24) adjacent to the upper end portion is defined by contact elements (60) arranged in the housing (12).

13. The extendable and retractable display device according to any one of claims 1 to 12, **characterized by** two actuators (36) which are arranged on both sides of the display foil (18) and the display foil carrier (24) and are connected to the upper end portion (26) of the display foil carrier (24).

14. The extendable and retractable display device according to any one of claims 1 to 12, **characterized by** an actuator (36) and a support (38) which are arranged on both sides of the display foil (18) and the display foil carrier (24) and are connected to the upper end portion (26) of the display foil carrier (24).

15. The extendable and retractable display device according to any one of claims 1 to 14, **characterized in that** the guiding means (52) has two guiding slots (77) opposite each other and that the display foil carrier (24) has lateral edges (54) extending along its main portion (30), from which guiding pins (76) cooperating with the guiding slot (77) project or protrude laterally for guiding the display foil carrier (24).

16. The extendable and retractable display device according to any one of claims 1 to 15, **characterized in that** the display foil carrier (24) is provided with a stiffening zone (70) at its end of its main portion (30) facing away from the upper end portion (26).

17. The extendable and retractable display device according to claim 16, **characterized in that** the guiding pins (76) are arranged in the area of the stiffening zone (70) of the main portion (30) of the display foil carrier (24).

18. The extendable and retractable display device according to claim 16 or 17, **characterized in that** a carrier element (72) with a rigid or flexible printed circuit board (74) protrudes at an angle from the stiffening zone (70).

19. The extendable and retractable display device according to any one of claims 1 to 18, **characterized in that** the guiding means (52) has two opposing guiding bodies (78) which are rotatably mounted and each have a curved outer edge (84), and that the guiding bodies (78) pivot when the display foil (18) and the display foil carrier (24) are extended and retracted, thereby supporting the display foil carrier (24) on the lateral edge side.

20. The extendable and retractable display device according to claim 19, **characterized in that** the guiding bodies (78) are mechanically coupled to the display foil carrier (24) for driving the display foil carrier (24) when the display foil (18) and the display foil carrier (24) are retracted.

21. The extendable and retractable display device according to claim 19 or 20, **characterized in that** the guiding bodies (78) are formed as partial disk bodies (80) extending over an angle of less than 180 degrees or less than 135 degrees or less than 90 degrees.

22. The extendable and retractable display device according to claim 19 or 20, **characterized in that** the guiding bodies (78) are formed as partial ring bodies (82) extending over an angle of less than 180 degrees or less than 135 degrees or less than 90 degrees.

23. The extendable and retractable display device according to any one of claims 19 to 22, **characterized in that** each guiding body (78) has a driving end (88) for driving the display foil carrier (24).

24. The extendable and retractable display device according to claim 23, **characterized in that**, at the driving end (88) of each guiding body (78), a driving pin is arranged which protrudes from the lateral edge side of the display foil carrier (24) and immerses into a pin receptacle on the display foil carrier (24).

25. The extendable and retractable display device according to claim 19 and 24, **characterized in that** the driving pins of the guiding bodies (78) are immersed as guiding pins (76) into the guiding slots (77) of the guiding means (52).

26. The extendable and retractable display device according to any one of claims 23 to 25, **characterized in that** each guiding body (78) is rotatably mounted at its driving end (88) for pivoting into the housing (12), wherein the axis of rotation extends transversely to the direction of extension and retraction of the display foil (18) and the display foil carrier (24).

27. The extendable and retractable display device according to any one of claims 1 to 26, **characterized in that** the guiding means (52) has a biasing unit (102) for automatically retracting the display foil (18) and the display foil carrier (24) or at least for supporting an automatic retraction of the display foil (18) and the display foil carrier (24), wherein the biasing unit (102) is adapted to be biased when the at least one actuator (36) is extended and is releasable when the at least one actuator (36) is retracted in order to retract the display foil (18) and the display foil carrier (24).

28. The extendable and retractable display device according to claim 27, **characterized in that** the biasing unit (102) has at least one driving lever (106) with a pivot bearing and a spring tensioning mechanism (104), e.g. with a leg spring, coil spring or helical spring on its pivot bearing, and that the at least one driving lever (106) is mechanically coupled to one of the guiding bodies (78).

29. The extendable and retractable display device according to claim 27, **characterized in that** the biasing unit (102) has two driving levers (106), each of which is mechanically coupled to a different one of the guiding bodies (78).

30. The extendable and retractable display device according to any one of claims 1 to 29, **characterized in that** a stiffening carrier comprising stiffening fins (94) is arranged on the rear side of the display foil carrier (24) facing away from the display foil (18), the stiffening fins (94) of which extending transversely to the retraction and extension direction of the display foil (18) and the display foil carrier (24) are fastened to the display foil carrier (24) along strip-shaped regions, and that the at least one retaining element (69), if present, is arranged on one of the stiffening fins (94), or that several retaining elements (69), if present, are arranged on different ones of the stiffening fins (94).

## Revendications

1. Dispositif d'affichage déployable et escamotable pour véhicule, doté
- d'un film écran flexible (18) en technologie OLED, lequel comporte une face avant comportant une surface d'affichage (20) ainsi qu'une face arrière et une section terminale supérieure (32), à laquelle se raccorde une section principale (34) du film écran (18) s'étendant jusqu'à une extrémité inférieure du film écran (18),
- d'un support flexible de film écran (24), lequel est fixé à la face arrière du film écran (18) ou est relié à celui-ci au moyen d'une couche intermédiaire constituée en particulier d'un matériau élastique et est en outre prévu avec une section terminale supérieure (26), à laquelle se raccorde une section principale (30) du support de film écran (24) s'étendant jusqu'à une extrémité inférieure du support de film écran (24), dans lequel la section terminale supérieure (26) du support de film écran (24) s'appuie sur la section terminale supérieure (32) du film écran (18),
- d'un boîtier (12), à l'intérieur duquel le film écran (18) peut être escamoté avec le support de film écran (24) et hors duquel le film écran (18) peut être déployé avec le support de film écran (24), et
- d'au moins un vérin (36) de longueur variable et entraînable par moteur, lequel comporte une première extrémité (48) s'appuyant dans et/ou sur le boîtier (12) et une deuxième extrémité (44) sur laquelle est fixée la section terminale supérieure (26) du support de film écran (24),
**caractérisé**
- **en ce que** la section terminale supérieure (26) du support de film écran (24) est renforcée pour la rigidifier et
- **en ce qu'**un dispositif de guidage (52) est prévu dans le boîtier (12) afin de guider le film écran (18) et le support de film écran (24) dans au moins une zone partielle des sections principales (34, 30) de ceux-ci le long d'une ligne de pliage (56) sur moins de 180° ou moins de 135° ou moins de 90° lors d'un déploiement et escamotage d'au moins des zones partielles des sections principales (34, 30) du film écran (18) et du support de film écran (24) hors du boîtier (12) et dans celui-ci, résultant d'une variation de longueur de l'au moins un vérin (36).

2. Dispositif d'affichage déployable et escamotable selon la revendication 1, **caractérisé en ce que** l'au moins un vérin (36) comporte au moins deux éléments de vérin (62, 64, 66) disposés entre les deux extrémités, dans lequel des éléments de vérin (62, 64, 66) respectivement adjacents sont guidés de façon à coulisser l'un sur l'autre et/ou l'un dans l'autre.

3. Dispositif d'affichage déployable et escamotable selon la revendication 2, **caractérisé en ce que** le vérin (36) comporte un premier élément profilé de vérin sensiblement en forme de C, prévu avec un côté fermé et un côté ouvert, un deuxième élément profilé de vérin guidé de façon à coulisser dans le premier élément profilé de vérin, également sensiblement en forme de C, prévu avec un côté fermé et un côté ouvert, dont le côté fermé fait face au côté fermé du premier élément profilé de vérin, et un troisième élément profilé de vérin guidé de façon à coulisser dans le deuxième élément profilé de vérin, sensiblement en forme de C, prévu avec un côté fermé et un côté ouvert, dont le côté fermé recouvre le côté ouvert du deuxième élément profilé de vérin.

4. Dispositif d'affichage déployable et escamotable selon l'une des revendications 1 à 3, **caractérisé par** au moins un support (38) variable en longueur avec une première extrémité (50) s'appuyant dans le boîtier (12) et une deuxième extrémité (46) à laquelle est fixée la section terminale supérieure (26) du support de film écran (24).

5. Dispositif d'affichage déployable et escamotable selon la revendication 4, **caractérisé en ce que** l'au moins un support (38) comporte au moins deux éléments de support disposés entre les deux extrémités, dans lequel des éléments de support respectivement adjacents sont guidés de façon à coulisser l'un sur l'autre et/ou l'un dans l'autre.

6. Dispositif d'affichage déployable et escamotable selon la revendication 5, **caractérisé en ce que** le support (38) comporte un premier élément profilé de support sensiblement en forme de C, prévu avec un côté fermé et un côté ouvert, un deuxième élément profilé de support guidé de façon à coulisser dans le premier élément profilé de support, également sensiblement en forme de C, prévu avec un côté fermé et un côté ouvert, dont le côté fermé fait face au côté fermé du premier élément profilé de support, et un troisième élément profilé de support guidé de façon à coulisser dans le deuxième élément profilé de support, sensiblement en forme de C, prévu avec un côté fermé et un côté ouvert, dont le côté fermé recouvre le côté ouvert du deuxième élément profilé de support.

7. Dispositif d'affichage déployable et escamotable selon l'une des revendications 1 à 6, **caractérisé en ce qu'**au moins un vérin (36) ou au moins un de ses éléments de support et/ou, pour autant qu'ils soient présents, l'au moins un support (38) ou au moins un de ses éléments de support comporte une face intérieure tournée vers le support de film écran (24), sur laquelle une rainure d'accueil est formée ou disposée, **en ce qu'**au moins un élément de maintien (69) est disposé dans la section principale (30) du support de film écran (24), dépassant de la face arrière de ce dernier se détournant du film écran (18), à savoir sur une ligne imaginaire à l'opposé de la rainure d'accueil lors du déploiement et de l'escamotage du film écran (18) et du support de film écran (24) et **en ce que** l'au moins un élément de maintien (69) plonge dans la rainure d'accueil lors du déploiement du film écran (18) et du support de film écran (24) et s'enlève de la rainure d'accueil lors de l'escamotage du film écran (18) et du support de film écran (24).

8. Dispositif d'affichage déployable et escamotable selon la revendication 7, **caractérisé en ce que** l'au moins un élément de maintien (69) comporte une extrémité élargie ou coudée, se détournant du support de film écran (24), destinée à saisir par l'arrière une fente d'accueil (68) de la rainure d'accueil.

9. Dispositif d'affichage déployable et escamotable selon l'une des revendications 1 à 8, **caractérisé en ce que** le film écran (18) et le support de film écran (24), dans l'état escamoté dans le boîtier (12), dépassent au moins partiellement hors du boîtier (12) avec leurs sections terminales supérieures (32, 26).

10. Dispositif d'affichage déployable et escamotable selon l'une des revendications 1 à 9, **caractérisé en ce que** l'au moins un vérin (36) et, pour autant qu'il soit présent, l'au moins un support (38) est ou sont monté(s) de manière pivotante dans le boîtier (12) sur les premières extrémités respectives afin de pivoter les sections terminales supérieures (32, 26) du film écran (18) et du support de film écran (24) dans l'état escamoté dans le boîtier (12).

11. Dispositif d'affichage déployable et escamotable selon la revendication 10, **caractérisé en ce que** la deuxième extrémité (44) du vérin (36) et, pour autant qu'il soit présent, la deuxième extrémité (46) de l'au moins un support (38) est disposée de manière articulée ou flexible sur la section terminale supérieure (26) du support de film écran (24).

12. Dispositif d'affichage déployable et escamotable selon l'une des revendications 10 ou 11, **caractérisé en ce que** la première extrémité (48) de l'au moins un vérin (36) et, pour autant qu'il soit présent, la première extrémité (50) de l'au moins un support (38), dans l'état escamoté du film écran (18) et du support de film écran (24), peut ou peuvent écarté(s) de la face arrière du support de film écran (24) et pivoté(s) dans le boîtier (12) dans la position écartée, dans lequel en particulier dans l'état pivoté le degré de pliage de la zone partielle, adjacente à la section terminale supérieure, de la section principale du film écran (18) et du support de film écran (24) est défini par des éléments d'appui (60) disposés dans le boîtier (12).

13. Dispositif d'affichage déployable et escamotable selon l'une des revendications 1 à 12, **caractérisé par** deux vérins (36), lesquels sont disposés des deux côtés du film écran (18) et du support de film écran (24) et sont reliés à la section terminale supérieure (26) du support de film écran (24).

14. Dispositif d'affichage déployable et escamotable selon l'une des revendications 1 à 12, **caractérisé par** un vérin (36) et un support (38), lesquels sont disposés des deux côtés du film écran (18) et du support de film écran (24) et sont reliés à la section terminale supérieure (26) du support de film écran (24).

15. Dispositif d'affichage déployable et escamotable selon l'une des revendications 1 à 14, **caractérisé en ce que** le dispositif de guidage (52) comporte deux fentes de guidage (77) se faisant face mutuellement et **en ce que** le support de film écran (24) comporte des bords latéraux (54) le long de sa section principale (30), desquels des broches de guidage (76), coopérant avec la fente de guidage (77) pour guider le support de film écran (24), saillent ou dépassent latéralement.

16. Dispositif d'affichage déployable et escamotable selon l'une des revendications 1 à 15, **caractérisé en ce que** le support de film écran (24) est prévu avec une zone de renfort (70) à son extrémité de sa section principale (30) se détournant de la section terminale supérieure (26).

17. Dispositif d'affichage déployable et escamotable selon la revendication 16, **caractérisé en ce que** les broches de guidage (76) sont disposées dans la région de la zone de renfort (70) de la section principale (30) du support de film écran (24).

18. Dispositif d'affichage déployable et escamotable selon la revendication 16 ou 17, **caractérisé en ce qu'**un élément porteur (72) doté d'un circuit imprimé (74) rigide ou flexible dépasse de la zone de renfort (70) avec un angle.

19. Dispositif d'affichage déployable et escamotable selon l'une des revendications 1 à 18, **caractérisé en ce que** le dispositif de guidage (52) comporte deux corps de guidage (78) se faisant face mutuellement, lesquels sont montés en rotation et comportent respectivement un bord externe recourbé (84), et **en ce que** les corps de guidage (78) pivotent et soutiennent ainsi le support de film écran (24) sur ses bords latéraux lors du déploiement et de l'escamotage du film écran (18) et du support de film écran (24).

20. Dispositif d'affichage déployable et escamotable selon la revendication 19, **caractérisé en ce que** les corps de guidage (78) sont couplés mécaniquement avec le support de film écran (24) pour l'entraînement de celui-ci lors de l'escamotage du film écran (18) et du support de film écran (24).

21. Dispositif d'affichage déployable et escamotable selon la revendication 19 ou 20, **caractérisé en ce que** les corps de guidage (78) sont réalisés comme corps en portion de disque (80), lesquels s'étendent sur un angle inférieur à 180° ou inférieur à 135° ou inférieur à 90°.

22. Dispositif d'affichage déployable et escamotable selon la revendication 19 ou 20, **caractérisé en ce que** les corps de guidage (78) sont réalisés comme corps en portion d'anneau (82), lesquels s'étendent sur un angle inférieur à 180° ou inférieur à 135° ou inférieur à 90°.

23. Dispositif d'affichage déployable et escamotable selon l'une des revendications 19 à 22, **caractérisé en ce que** chaque corps de guidage (78) comporte une extrémité d'entraînement (88) afin d'entraîner le support de film écran (24).

24. Dispositif d'affichage déployable et escamotable selon la revendication 23, **caractérisé en ce qu'**aux extrémités d'entraînement (88) de chaque corps de guidage (78) est disposée une broche d'entraînement dépassant du bord latéral du support de film écran (24), laquelle plonge dans un accueil de broche sur le support de film écran (24).

25. Dispositif d'affichage déployable et escamotable selon la revendication 19 et 24, **caractérisé en ce que** les broches d'entraînement des corps de guidage (78) sont plongées comme broches de guidage (76) dans les fentes de guidage (77) du dispositif de guidage (52).

26. Dispositif d'affichage déployable et escamotable selon l'une des revendications 23 à 25, **caractérisé en ce que** chaque corps de guidage (78) est monté en rotation à son extrémité d'entraînement (88) afin de pivoter dans le boîtier (12), dans lequel l'axe de rotation est transversal par rapport à la direction de déploiement et d'escamotage du film écran (18) et du support de film écran (24).

27. Dispositif d'affichage déployable et escamotable selon l'une des revendications 1 à 26, **caractérisé en ce que** le dispositif de guidage (52) comporte une unité de précontrainte (102) destinée à l'escamotage automatique du film écran (18) et du support de film écran (24) ou au moins destinée à assister un escamotage automatique du film écran (18) et du support de film écran (24), dans lequel l'unité de précontrainte (102) peut se tendre lors du déploiement de l'au moins un vérin (36) et peut se détendre lors de l'escamotage de l'au moins un vérin (36) destiné à l'escamotage du film écran (18) et du support de film écran (24).

28. Dispositif d'affichage déployable et escamotable selon la revendication 27, **caractérisé en ce que** l'unité de précontrainte (102) comporte au moins un levier d'entraînement (106) avec palier tournant et un mécanisme de tension de ressort (104) par exemple avec un ressort à branches, spiralé ou hélicoïdal sur son palier tournant et **en ce que** l'au moins un levier d'entraînement (106) est couplé mécaniquement à l'un des corps de guidage (78).

29. Dispositif d'affichage déployable et escamotable selon la revendication 27, **caractérisé en ce que** l'unité de précontrainte (102) comporte deux leviers d'entraînement (106), lesquels sont couplés mécaniquement à un autre des corps de guidage (78).

30. Dispositif d'affichage déployable et escamotable selon l'une des revendications 1 à 29, **caractérisé en ce qu'**un support de renfort comportant des lamelles de renfort (94) est disposé sur la face arrière du support de film écran (24) se détournant du film écran (18), dont les lamelles de renfort (94) transversales par rapport à la direction de déploiement et d'escamotage du film écran (18) et du support de film écran (24) sont fixées sur le support de film écran (24) le long de zones en forme de bande et **en ce que** l'au moins un élément de maintien (69), pour autant qu'il soit présent, est disposé sur l'une des lamelles de renfort (94) ou **en ce que** plusieurs éléments de maintien (69), pour autant qu'ils soient présents, sont disposés sur différentes lamelles de renfort (94).
